# EUROPEAN PATENT APPLICATION

(11) **EP 1 130 423 A1**
(43) Date of publication of application: **05.09.2001**
(21) Application number: 01104560.6
(22) Date of filing: 05.03.2001
(51) Int. Cl.: G02B 5/20, G03F 7/00, G02F 1/1335, G03F 7/027

(54) **Color filter composition and color filter made therefrom**

(30) Priority: 03.03.2000 JP 2000059161
(71) Applicant: Fujifilm Olin Co., Ltd., Tokyo (JP)
(72) Inventor: Enokido, Masashi, Fujifilm Olin Co., Ltd., Haibara-gun, Shizuoka (JP)
(74) Representative: HOFFMANN - EITLE

(57) **Abstract**

Provided are a color filter composition comprising a pigment, wherein the composition in the coated form exhibits such a color density distribution that the frequencies of a relative color density not greater than -10% amount to 0.3% or less of the entire frequencies and the frequencies of the relative color density between -5% to 5% amount to 95% or greater of the entire frequencies; and a color filter comprising on a substrate the composition. The improvement in the color filter according to the invention brings about an improvement in the uniformity of the sensitivity of all the pixels upon image sensing by a solid-state image sensing device such as CCD.

## Description

### BACKGROUND OF THE INVENTION

### 1. Field of the Invention

The present invention relates to a composition for a color filter used for recording (sensing) of visual information by a solid-state image sensing device (which will hereinafter be typified by CCD) such as CCD, MOS, CMOS, CID or CPD; and a color filter made of the composition.

### 2. Description of the Related Art

CCD is a device of collecting lights, through a color filter, onto a photo diode disposed in each picture element and optoelectrically transducing them, thereby converting them into picture information divided into fine picture elements. Accordingly, the more uniform the voltage value (sensitivity) available from each of the picture elements as a result of optoelectric transduction, the better the reproducibility of the real image by picture information.

In order to impart each of picture elements with uniform sensitivity, a composition as described in JP-A-6-51522 (the term "JP-A" as used herein means an "unexamined published Japanese patent application) which contains particles having a particle size of 1 µm in an amount of not more than 10 % by weight of all the particles has conventionally been used.

With a tendency to reduce the pixel size of CCD from 8 to 20 µm, the conventional size, to 4 µm or 3 µm, however, use of such a composition has caused a problem of a rise in the number of defective pixels having a low output, that is, black defects owing to an increase in variations in the output level of each of pixels.

### SUMMARY OF THE INVENTION

With the foregoing in view, the present invention has been completed. An object of the present invention is therefore to improve a color filter, thereby imparting all the pixels with improved uniformity in image sensing by CCD.

The above-described object is attained by the following color filter available from the following composition having specific properties.
(1) A color filter composition comprising a pigment, wherein said composition in the coated form exhibits such a color density distribution that the frequencies of a relative color density not greater than -10% amount to 0.3% or less and the frequencies of the relative color density between -5% to 5% amount to 95% or greater, each of the entire frequencies.
(2) A color filter comprising on a substrate or on a chip the color filter composition as described above in (1).
(3) The color filter composition as described above in (1), which further comprises a photopolymerizable composition comprising, at least one organic polymer having, on a part of the side chain thereof, a water soluble atom group; at least one photopolymerizable ethylenically unsaturated compound containing at least two terminal ethylene groups and having a boiling point of 100°C or greater under normal pressures; at least one photopolymerization initiator to be activated by exposure to active electromagnetic waves; and at least one solvent.

The term "color density distribution" as used herein means the distribution of the density of each of red, blue and green colors of each of the pixels in the picture image. For example, a transmitted picture image is imported into a computer through a bitmap system of 8 bits per pixel by using an optical microscope, a digital camera and an image importing software. Upon importing, the luminous quantity and importing time are adjusted to give the value of a specific color component within a range of 1 to 254, whereby the density distribution of the image processed as that of a bitmap system can be obtained.

The relative color density is determined based on the following equation with the average of the color density distribution thus obtained as an average color density (Cₐᵥₑ).

Relative color density = (color density of each pixel - Cₐᵥₑ) / Cₐᵥₑ × 100%

The smaller one pixel unit, the color density distribution varies largely. The area per pixel is in inverse proportion to "magnification of a microscope" x "the number of pixels of CCD which imports a picture image". As the magnification of the microscope is greater or as the number of the pixels of CCD to import an image therein is larger, the color density distribution varies largely. The magnification of a microscope and the number of the pixels of CCD are selected as needed according to the using purpose. Import of a transmitted image, which has been obtained at about 1000 magnifications, by using about 1 million-pixel CCD through a bitmap system of 8 bits per pixel can be mentioned as an example suited for the object of the invention.

### BRIEF DESCRIPTION OF THE DRAWINGS

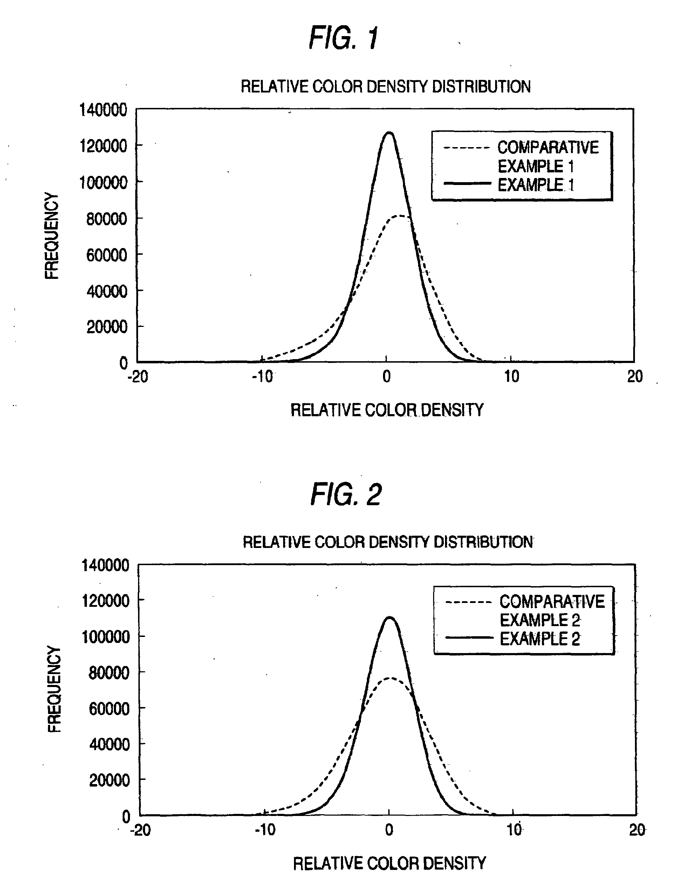

FIG. 1 illustrates the relative color density distribution of Example 1 and Comparative Example 1; and FIG. 2 illustrates the relative color density distribution of Example 2 and Comparative Example 2.

### DETAILED DESCRIPTION OF THE INVENTION

There is no particular limitation imposed on the fabrication method of the color filter of the present invention. Methods such as printing method, electrodeposition method and photolithography which forms a pattern in combination with a resist can be employed. As a preferable fabrication method, use of a pigment and a photopolymerizable composition in combination will next be described specifically.

The term "pigment" as used herein means a coloring powder sparingly soluble in water or an organic solvent and it includes organic pigments and inorganic pigments. Specific examples include inorganic pigments such as barium sulfate, zinc oxide, lead sulfate, titanium oxide, yellow lead (oxide), red oxide, ultramarine, iron blue, chromium oxide and carbon black; and organic pigments such as benzidine yellow G, benzidine yellow GR, lithol fast orange 3GL, vulcan fast orange GG, pigment scarlet 3B, thioindigo maroon, phthalocyanine blue, phthalocyanine green, indanthrene blue, green gold and malachite green lake. More specific examples will next be described using a color index (C.I.) number.
C.I. yellow pigments 20, 24, 83, 86, 93, 109, 110, 117, 125, 137, 138, 139, 147, 148, 150, 153, 154, 166, 168, 185
C.I. orange pigments 36, 43, 51, 55, 59, 61
C.I. red pigments 9, 97, 122, 123, 149, 168, 177, 180, 192, 215, 216 or 217, 220, 223, 224, 226, 227, 228, 240, 242, 244, 254
C.I. violet pigments 19, 23, 29, 30, 37, 40, 50
C.I. blue pigments 15, 15:3, 15:6, 22, 60, 64
C.I. green pigments 7, 36
C.I. brown pigments 23, 25, 26
C.I. black pigment 7

Examples of the pigment include combined use of C.I. Pigment Red 244 and C.I. Pigment Red 177 for red color, combined use of C.I. Pigment Green 36 and C.I. Pigment Yellow 139 or C.I. Pigment Yellow 83 for green color, single use of C.I. Pigment Blue 15:6 or combined use of C.I. Pigment Blue 15:6 and C.I. Pigment Violet 23 for blue color. Any combination can be employed insofar as it satisfies the relative color density as defined by this invention.

The photopolymerizable composition of the invention is composed at least of an organic polymer having, on a part of the side chain thereof, a water soluble atom group; at least one photopolymerizable ethylenically unsaturated compound which contains at least two terminal ethylene groups and has a boiling point of 100°C or greater under normal pressures; a photopolymerization initiator to be activated by exposure to an active electromagnetic wave; and a solvent.

Examples of the photopolymerizable ethylenically unsaturated compound (which may hereinafter be called "monomer" simply) which contains at least two terminal ethylene groups and has a boiling point of 100°C or greater under normal pressures include monofunctional acrylates or methacrylates such as polyethylene glycol mono(meth)acrylate, polypropylene glycol mono(meth)acrylate and phenoxyethyl (meth)acrylate; and polyfunctional acrylates or methacrylates such as polyethylene glycol di(meth)acrylate, trimethylolethane tri(meth)acrylate, neopentylglycol (meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylolpropane tri(acryloyloxypropyl)ether, tri(acryloyloxyethyl) isocyanurate, compounds obtained by adding, to a polyfunctional alcohol such as glycerin or trimethylolethane, ethylene oxide or propylene oxide and then converting the resulting mixture into the corresponding meth(acrylate), urethane acrylates as described in JP-B-48-41708 (the term "JP-B" as used herein means an "examined Japanese patent publication"), JP-B-50-6034 or JP-A-51-37193, polyester acrylates as described in JP-A-48-64183, JP-B-49-43191 or JP-B-52-30490 and epoxy acrylates which are reaction products of an epoxy resin and (meth)acrylic acid.

In addition, compounds introduced as a photo-setting monomer or oligomer in *Journal of the Adhesion Society of Japan,* 20, pp. 300-308 (1984)" are also usable. The above-exemplified monomers or oligomers may be used either singly or in combination. The amount of such a compound may be added in an amount of 5 to 50 % by weight, preferably 10 to 40 % by weight, based on the solid content of the photopolymerizable composition.

As the organic polymer (which may hereinafter be called "binder" simply) having, on a part of the side chain thereof, a water soluble atom group, preferred are linear organic polymers which have compatibility with the monomer, soluble in an organic solvent and can be developed in a weak alkaline aqueous solution. Examples of such a polymer include polymers having, on the side chain thereof, a carboxylic acid, for example, methacrylic acid copolymers, acrylic acid copolymers, itaconic acid copolymers, crotonic acid copolymers, maleic acid copolymers and partially esterified maleic acid copolymers as described in JP-A-59-44615, JP-B-54-34327, JP-B-58-12577, JP-B-54-25957, JP-A-59-53836 or JP-A-59-71048. Acid cellulose derivatives having, on the side chain thereof, a carboxylic acid can also be employed.

In addition, hydroxyl-containing polymers added with an acid anhydride are useful. Among them, preferred are benzyl (meth)acrylate-(meth)acrylic acid copolymers and multi-element copolymers of benzyl (meth)acrylate-(meth)acrylic acid-the other monomer. The above-exemplified polymer can be added freely, but amounts exceeding 90 % by weight based on the solid content of the photopolymerizable composition do not bring about good results in the image intensity formed through the resulting filter. Amounts within a range of from 30 to 85 % by weight are preferred.

As the photopolymerization initiator to be activated by exposure to active electromagnetic waves, at least one trihalomethyl compound is usable, but it may be combined with the below-exemplified material. Examples of the material usable in combination include a vicinal polyketoaldonyl compound as disclosed in U.S. Patent 2,367,660, an α-carbonyl compound as disclosed in U.S. Patents 2,367,661 and 2,367,670, an acyloin ether compound as disclosed in U.S. Patent 2,448,828, an aromatic acyloin compound substituted with α-hydrocarbon as disclosed in U.S. Patent 2,722,512, a multinuclear quinone compound as disclosed in U.S. Patents 3,046,127 and 2,951,758, a combination of triallyl imidazole dimer with p-aminophenyl ketone as disclosed in U.S. Patent 3,549,367 and an oxadiazole compound as described in U.S. Patent 4,212,976. The trihalomethyl compound is added in an amount of preferably about 0.2 to 20 % by weight, more preferably 0.5 to 15 % by weight relative to the solid content of the monomer.

The compound to be used in combination with the trihalomethyl compound is added in an amount of preferably 10 to 800 % by weight, more preferably 20 to 300 % by weight, relative to the trihalomethyl compound.

Examples of the solvent to be used upon preparation of the invention composition include esters such as ethyl acetate, n-butyl acetate, isobutyl acetate, amyl formate, isoamyl acetate, isobutyl acetate, butyl propionate, isopropyl butyrate, ethyl butyrate and butyl butyrate; alkyl esters such as methyl lactate, ethyl lactate, methyl oxyacetate, ethyl oxyacetate, butyl oxyacetate, methyl methoxyacetate, ethyl methoxyacetate, butyl methoxyacetate, methyl ethoxyacetate, ethyl ethoxyacetate, alkyl 3-oxypropionates, for example, methyl 3-oxypropionate and ethyl 3-oxypropionates, methyl 3-methoxypropionate, ethyl 3-methoxypropionate, methyl 3-ethoxypropionate, ethyl 3-ethoxypropionate, methyl 2-oxypropionate, ethyl 2-oxypropionate, propyl 2-oxypropionate, methyl 2-methoxypropionate, ethyl 2-methoxypropionate, propyl 2-methoxypropionate, methyl 2-ethoxypropionate, ethyl 2-ethoxypropionate, methyl 2-oxy-2-methylpropionate, ethyl 2-oxy-2-methylpropionate, methyl 2-methoxy-2-methylpropionate, ethyl 2-ethoxy-2-methylpropionate, methyl pyruvate, ethyl pyruvate, propyl pyruvate, methyl acetoacetate, ethyl acetoacetate, methyl 2-oxobutanoate and ethyl 2-oxobutanoate; ethers such as diethylene glycol dimethyl ether, tetrahydrofuran, ethylene glycol monomethyl ether, ethylene glycol monoethyl ether, methylcellosolve acetate, ethyl cellosolve acetate, diethylene glycol monomethyl ether, diethylene glycol monoethyl ether, diethylene glycol monobutyl ether, propylene glycol methyl ether acetate, propylene glycol ethyl ether acetate and propylene glycol propylether acetate; ketones such as methyl ethyl ketone, cyclohexanone, 2-heptanone and 3-heptanone; and aromatic hydrocarbons such as toluene and xylene.

Among them, preferred are methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, ethyl carbitol acetate, butyl carbitol acetate, and propylene glycol methyl ether acetate. These solvents may be used either singly or in combination.

To the composition of the invention, a dispersant can be added in order to improve the dispersibility of the pigment. Many kinds of dispersants can be used and examples include cationic surfactants, fluorine surfactants and polymer dispersants.

A graft copolymer as described in JP-A-10-254133, which has, at the main chain thereof, a specific acid-amide-containing monomer and a quaternary ammonium salt monomer residue has excellent action of finely dispersing a pigment so that use of it makes it possible to finely disperse a pigment without spending much energy or time and to obtain a pigment composition having good dispersion stability for a long period time without causing cohesion or precipitation even with the passage of time. As a dispersant, this compound can preferably be incorporated in the composition of the invention. The above-described dispersants may be used either singly or in combination. Such a dispersant may usually be added in an amount of 0.1 to 50 parts by weight based on 100 parts by weight of the pigment.

To the composition of the invention, various additives other than those described above, for example, filler, surfactant, adhesion accelerator, antioxidant, ultraviolet absorber or cohesion inhibitor can be added as needed.

Further, addition of a thermal polymerization inhibitor is ordinarily conducted in order to improve storage stability of the composition of the invention.

In addition, for the promotion of alkali solubility of a portion unexposed to radiation and further improvement of the developing properties of the composition of the invention, an organic carboxylic acid, preferably a low-molecular weight organic carboxylic acid having a molecular weight of 1000 or less can be added.

The composition of the invention can be prepared by mixing and dispersing the pigment and the above-described materials in a mixer or dispersing machine. As the mixer or dispersing machine, those conventionally known can be used. Examples include homogenizer, kneader, ball mill, twin or triple roll mill, paint shaker, sand grinder or sand mill such as DYNO-MILL.

The composition of the present invention is preferably prepared in the following manner. After addition of a solvent to a pigment and a binder and mixing them uniformly, the resulting mixture is kneaded by a twin or triple roll mill, if necessary, under heating to wet the pigment with the binder sufficiently, whereby a uniformly colored mass is obtained. To the resulting colored mass are added a solvent, a monomer and a photopolymerization initiator and, if necessary, a dispersant and various additives, followed by dispersion in a ball mill or a sand mill, such as DYNO-MILL, using glass beads as a dispersing medium. Upon dispersion, the smaller the particle size of the glass beads, the finer the dispersion becomes. At this time, adjustment of the dispersed liquid at a predetermined temperature results in dispersion with good reproducibility.

From the thus obtained dispersion, coarse particles can be removed by centrifugation, filtration or decantation as needed.

The composition of the present invention thus obtained is then applied to a substrate by a coating method such as spin coating, cast coating or roll coating to form a radiation sensitive composition layer. Through a predetermined mask pattern, the resulting radiation sensitive composition layer is exposed to light, followed by development in a developer, whereby a colored pattern is formed. As the radiation, ultraviolet rays such as g-line and i-line are particularly preferred. The term "radiation" as used herein is a generic term for visible rays, ultraviolet rays, far ultraviolet rays and X rays.

As a substrate, a photoelectric conversion element substrate used for a solid-state image sensing device, for example, a silicon substrate is employed. In addition, soda glass used for a liquid crystal display device, Pyrex, quartz glass or glass obtained by adhering a transparent conductive film thereto may be used. On such a substrate, black stripes for separating pixels each other may usually be formed.

As a developing solution, any developing solution is usable insofar as it dissolves therein an unexposed portion but does not dissolve an exposed portion of the radiation sensitive composition. As the developing solution, various organic solvents can be used in combination or an alkali aqueous solution can be used. As the organic solvent, the above-exemplified organic solvents used for the preparation of the composition of the invention can be employed.

As the alkali, usable is an alkali aqueous solution obtained by dissolving an alkali compound such as sodium hydroxide, potassium hydroxide, sodium carbonate, sodium silicate, sodium metasilicate, aqueous ammonia, ethylamine, diethylamine, dimethylethanolamine, tetramethylammonium hydroxide, tetraethylammonium hydroxide, choline, pyrrole, piperidine or 1,8-diazabicyclo-[5.4.0]-7-undecene in water in an amount of 0.001 to 10 % by weight, preferably 0.01 to 1 by weight. Development in such an aqueous alkali aqueous solution must usually be followed by washing with water.

### EXAMPLES

The invention will hereinafter be described in further detail by Examples. It should however be borne in mind that the invention is not limited to or by these Examples.

### Example 1

A mixture composed of:
12 parts of a benzyl methacrylate - methacrylic acid copolymer,
15 parts of C.I. Pigment Green 36,
5 parts of C.I. Pigment Yellow 139, and
20 parts of propylene glycol monomethyl ether acetate was kneaded in a triple roll mill. To the resulting kneaded mass were added:
   50 parts of propylene glycol monomethyl ether acetate, and
   50 parts of ethyl 3-ethoxypropionate, followed by dispersion in a beads mill using beads having a diameter of 0.2 mm.

To the resulting dispersion were added:
40 parts of dipentaerythritol pentaacrylate,
3 parts of 4-[o-bromo-p-N,N-di(ethoxycarbonyl)aminophenyl]-2,6-di(trichloromethyl)-S-triazine,
2 parts of 7-[{4-chloro-6-(diethylamino)-S-triazin-2-yl}amino]-3-phenylcoumarin,
0.01 parts of hydroquinone monomethyl ether, and
200 parts of propylene glycol monomethyl ether acetate. The resulting mixture was stirred, followed by centrifugation at 15,000 rpm and filtration through a filter of 1 µm, whereby the composition of the invention was obtained.

The resulting composition was applied onto a transparent glass substrate by using a spin coater, dried, exposed to light and dried to obtain a coated substrate having a film thickness of 1.5 µm.

A picture image, which had been obtained at 1000 magnifications, was transmitted through the resulting coated substrate and was imported into a personal computer in a bitmap system of 8 bits by using an optical microscope ("OLYMPUS BX60", trade name), a 1.28 million-pixel digital camera ("FUJI DIJITAL CAMERA HC-300", trade name; product of Fuji Film Co., Ltd.) and an image importing software ("photograb-300", trade name; product of Fuji Film Co., Ltd.). Upon importing the image, the luminous energy and importing time were adjusted to give the numeral of a green component within a range of 1 to 254.

In the relative color density distribution of the green component of the coated substrate, the frequencies not greater than -10% amounted to 0.12% of the entire frequencies, while those between from -5% to 5% amounted to 97.4% of the entire frequencies.

The uniformity of the sensitivity of pixels was evaluated by counting the number of black defects as lowoutput defective pixels in a 3 µm x 3 µm, 1-million-pixel CCD.

### Comparative Example 1

In a similar manner to Example 1 except that the centrifugation was omitted, a coated substrate was obtained. In the relative color density distribution of the green component of the thus-obtained coated substrate, the frequencies not greater than -10% amounted to 1.37% of the entire frequencies, while those between-5% to 5% amounted to 88.6% of the entire frequencies.

### Example 2

In a similar manner to Example 1 except for the use of C.I. Pigment Blue 15:6 and C.I. Pigment violet 23 instead of C.I. Pigment Green 36 and C.I. Pigment yellow 139, respectively, a coated substrate was obtained. In the relative color density distribution of the blue component of the thus-obtained coated substrate, the frequencies of -10% or less amounted to 0.13% of the entire frequencies, while those ranging from -5% to 5% amounted to 98.1% of the entire frequencies.

### Comparative Example 2

In a similar manner to Example 2 except that the particle size of the beads was changed to 0.5 mm, a coated substrate was obtained. In the relative color density distribution of the blue component of the thus-obtained coated substrate, the frequencies not greater than -10% or less amounted to 0.47% of the entire frequencies, while those between -5% to 5% amounted to 88.0% of the entire frequencies.

In FIG. 1, illustrated is the relative color density distribution of the green component of each of the coated substrates of Example 1 and Comparative Example 1. In FIG. 2, illustrated is the relative color density distribution of the green component of each of the coated substrates of Example 2 and Comparative Example 2.

In Table 1, shown are a ratio of the frequencies of the relative color density not greater than -10% and a ratio of the frequencies ranging from -5% to 5% and the number of black defects. From the diagrams and table, it has been found that the uniformity of the pixels in Examples are superior to that in Comparative Examples.

**Table 1**

| | A ratio of frequencies of relative color density not greater than -10% | A ratio of frequencies of relative color density between from -5% to 5% | The number of black defects |
|---|---|---|---|
| Example 1 | 0.12% | 97.4% | 5 |
| Comp. Ex. 1 | 1.37% | 88.6% | 158 |
| Example 2 | 0.13% | 98.1% | 8 |
| Comp. Ex. 2 | 0.47% | 88.0% | 113 |

The present invention makes it possible to provide a color filter and a color filter composition suited for recording (sensing) of visual information by a solid-state image sensing device such as CCD, MOS, CMOS, CID or CPD.

While the invention has been described in detail and with reference to specific embodiments thereof, it will be apparent to one skilled in the art that various changes and modifications can be made therein without departing from the spirit and scope thereof.

This application is based on Japanese patent application No. 2000-059161 filed on March 3, 2000, the entire contents of which incorporated herein by reference.

## Claims

1. A color filter composition comprising a pigment, wherein said composition in the coated form exhibits such a color density distribution that the frequencies of a relative color density not greater than -10% amount to 0.3% or less and the frequencies of the relative color density between -5% to 5% amount to 95% or greater, each of the entire frequencies.

2. A color filter comprising on a substrate or on a chip said color filter composition of claim 1.

3. The color filter composition according to claim 1, which further comprises a photopolymerizable composition comprising:
at least one organic polymer having, on a part of the side chain thereof, a water soluble atom group;
at least one photopolymerizable ethylenically unsaturated compound containing at least two terminal ethylene groups and having a boiling point of 100°C or greater under normal pressures;
at least one photopolymerization initiator to be activated by exposure to active electromagnetic waves; and
at least one solvent.

4. The color filter composition according to claim 3, wherein the photopolymerizable ethylenically unsaturated compound is contained in an amount of 5 to 50 % by weight based on the solid content of the photopolymerizable composition.

5. The color filter composition according to claim 3, wherein the photopolymerizable ethylenically unsaturated compound is contained in an amount of 10 to 40 % by weight based on the solid content of the photopolymerizable composition.

6. The color filter composition according to claim 3, wherein the organic polymer is contained in an amount of 30 to 85 % by weight based on the solid content of the photopolymerizable composition.

7. The color filter composition according to claim 3, wherein the photopolymerization initiator is a trihalomethyl compound.

8. The color filter composition according to claim 7, wherein the trihalomethyl compound is contained in an amount of about 0.2 to 20 % by weight relative to the solid content of the monomer.
